# DEMANDE DE BREVET EUROPEEN

(11) **EP 1 808 886 A2**
(43) Date de publication de la demande: **18.07.2007**
(21) Numéro de dépôt: 07100648.0
(22) Date de dépôt: 17.01.2007
(51) Int. Cl.: H01L 21/265

(54) **Procédé d'ajustement de la contrainte d'un substrat en un matériau semi-conducteur**

(30) Priorité: 17.01.2006 FR 0600398; 10.03.2006 US 372868
(71) Demandeur: S.O.I.T.E.C. Silicon on Insulator Technologies, F-38190 Bernin (FR)
(72) Inventeur: Le Vaillant, Yves Matthieu, 38920 Crolles (FR)
(74) Mandataire: Collin, Jérôme

(57) **Abrégé**

L'invention concerne un procédé d'ajustement de la contrainte d'une couche contrainte (2) sur un substrat (1), comprenant les étapes consistant à :
- identifier une ou des régions (21, 22) de la couche contrainte (2) dans lesquelles on souhaite ajuster la contrainte par une mesure de cette contrainte ;
- implanter des éléments dans au moins une des régions (21, 22) de la couche contrainte (2) ainsi identifiées ;
- effectuer un recuit du substrat (1) avec la couche contrainte (2) à une température maintenue pendant une durée suffisante pour guérir les défauts cristallins dus à l'implantation dans la (21) ou les régions implantées (21, 22).

## Description

L'invention concerne un procédé d'ajustement de la contrainte à la surface ou à l'intérieur d'un substrat en un matériau semi-conducteur.

L'invention concerne par exemple un procédé d'ajustement local de la contrainte d'une ou plusieurs couches sur un substrat en un matériau semi-conducteur.

L'invention concerne également un procédé d'ajustement de la contrainte d'une partie de la surface ou de la surface entière d'un substrat en un matériau semi-conducteur ayant une couche contrainte superficielle ou enterrée.

De manière générale, l'invention s'applique à tous types de couches contraintes sur un substrat en un matériau conducteur et présentant une inhomogénéité de contrainte, à la surface de la couche ou dans la profondeur de cette couche.

Le procédé selon l'invention est de plus particulièrement bien adapté pour l'ajustement local de la contrainte d'une couche obtenue par épitaxie sur un substrat.

L'invention concerne également une couche contrainte sur un substrat en un matériau semi-conducteur obtenue par le procédé selon l'invention.

L'invention concerne enfin une tranche de matériau semi-conducteur comprenant au moins une telle couche.

### Art antérieur

L'utilisation d'une couche contrainte sur un substrat est particulièrement intéressante car elle permet d'augmenter la mobilité des porteurs de charges au sein de structures semi-conductrices.

L'homme de l'art connaît plusieurs techniques et procédés permettant de créer une contrainte dans une couche sur un substrat.

Par exemple, la contrainte au sein d'une couche de Silicium peut être obtenue par épitaxie sur un substrat dont le paramètre de maille élémentaire dans le plan d'épitaxie diffère de celui du Silicium. Un tel procédé est plus connu sous le nom d'épitaxie pseudomorphe.

Or, avec ce procédé, l'analyse de la couche contrainte à la surface de celle-ci montre qu'il existe une inhomogénéité de la contrainte de l'ordre de 1% de la contrainte maximale mesurée entre le centre et le bord du substrat.

Avec ce procédé, les sources de cette inhomogénéité de contrainte de la couche du substrat peuvent être :
- une inhomogénéité de la composition de l'alliage (SiGe par exemple) du pseudo-substrat obtenu par épitaxie sur le substrat massif (homogénéité de la température sur le pseudo-substrat pendant l'épitaxie, constance des écoulements gazeux dans le réacteur) ;
- la relaxation de la contrainte due aux traitements thermiques (oxydation thermique, traitements thermiques post-épitaxie, etc.).

Les procédés actuels ne permettent ainsi d'obtenir la contrainte souhaitée dans la couche concernée qu'avec une précision limitée.

Or, il serait avantageux d'augmenter cette précision pour assurer une bonne mobilité des charges au sein de la couche contrainte.

Pour améliorer les procédés existants, il est bien sûr possible d'effectuer des contrôles plus fréquents de la température des lampes de chauffage et du débit des gaz dans le réacteur, tout comme il est possible d'améliorer la précision de ces installations.

Une autre possibilité est de prévoir un procédé de traitement additionnel effectué après un procédé connu de réalisation d'une couche contrainte. L'objectif de la présente invention est de proposer un tel procédé.

### Résumé de l'invention

Cet objectif est atteint dans le cadre de la présente invention grâce à un procédé d'ajustement de la contrainte d'une couche contrainte sur un substrat, comprenant les étapes consistant à :
- identifier une ou des régions de la couche contrainte dans lesquelles on souhaite ajuster la contrainte ;
- implanter des éléments dans au moins une des régions de la couche contrainte ainsi identifiées ;
- effectuer un recuit du substrat avec la couche contrainte à une température maintenue pendant une durée suffisante pour guérir les défauts cristallins dus à l'implantation dans la ou les régions implantées.

Le procédé selon l'invention pourra en outre présenter au moins l'une des caractéristiques suivantes :
- l'ajustement de la contrainte est local ;
- la couche contrainte est superficielle ;
- la couche contrainte est enterrée sous d'autres couches ;
- la région identifiée est située en surface de la couche contrainte;
- la région identifiée est une région enterrée dans la couche contrainte ;
- les éléments implantés sont de nature identique à au moins l'un des éléments chimiques formant la couche contrainte ;
- l'étape de recuit est effectuée dans une gamme de température comprise entre 850°C et 950°C ;
- l'étape de recuit est effectuée à température constante pour une durée comprise entre deux et quatre heures ;
- l'étape de recuit est effectuée sous Argon à la température constante de 900°C pour une durée de trois heures ;
- on effectue plusieurs fois de suite l'étape d'implantation suivie de l'étape de recuit, pour traiter plusieurs régions de la couche contrainte.

Et s'appliquer à au moins l'un des éléments suivants :
- une couche contrainte ayant fait l'objet d'un procédé selon au moins une des caractéristiques énumérées ci-dessus ;
- une tranche de matériau semi-conducteur comprenant au moins une couche contrainte ayant fait l'objet d'un procédé selon au moins une des caractéristiques énumérées ci-dessus.

### Brève description des dessins

D'autres caractéristiques, buts et avantages de la présente invention apparaîtront à la lecture de la description détaillée qui va suivre, et en regard des dessins annexés, donnés à titre d'exemples non limitatifs et sur lesquels :
- Les figures 1, 2 et 3 représentent des vues de coupes d'une tranche de matériau semi-conducteur, formée d'un substrat et d'une couche contrainte au sein de laquelle sont illustrés respectivement différents types de régions pour lesquelles on souhaite ajuster la contrainte ;
- La figure 4 représente une vue de coupe d'une tranche de matériau semi-conducteur, formée d'un substrat et de plusieurs couches contraintes au sein desquelles sont illustrés différents types de régions pour lesquelles on souhaite ajuster la contrainte.

### Description détaillée de l'invention

La présente invention a pour objectif d'ajuster la contrainte d'une ou plusieurs couches contraintes sur un substrat. Par couche contrainte, il faut comprendre dans le cadre de l'invention une couche formée d'un matériau cristallin dont le paramètre de maille élémentaire diffère du paramètre de maille élémentaire naturel de ce matériau, dans des conditions de température et de pression données.

On cherche même, dans le cadre de l'invention, à effectuer un ajustement faible de cette contrainte car la mobilité des charges est très sensible à cette contrainte. En effet, la précision sur le niveau de contrainte dans la couche concernée présente un enjeu d'importance pour prévoir les performances des dispositifs microélectroniques ou optoélectroniques.

L'invention porte donc sur un procédé additionnel mis en oeuvre en fin de procédé de fabrication d'une couche contrainte sur un substrat et comprenant, après l'identification de la ou des régions de la couche contrainte dans lesquelles on souhaite ajuster la contrainte, une étape d'implantation d'éléments chimiques suivie d'une étape de traitement thermique (appelée également étape de recuit).

Pour identifier la ou les régions de la couche contrainte dans lesquelles on souhaite ajuster la contrainte, une mesure de cette contrainte doit être effectuée. Pour cela, une méthode de métrologie non destructive est employée, de type Raman ou diffraction à rayons X.

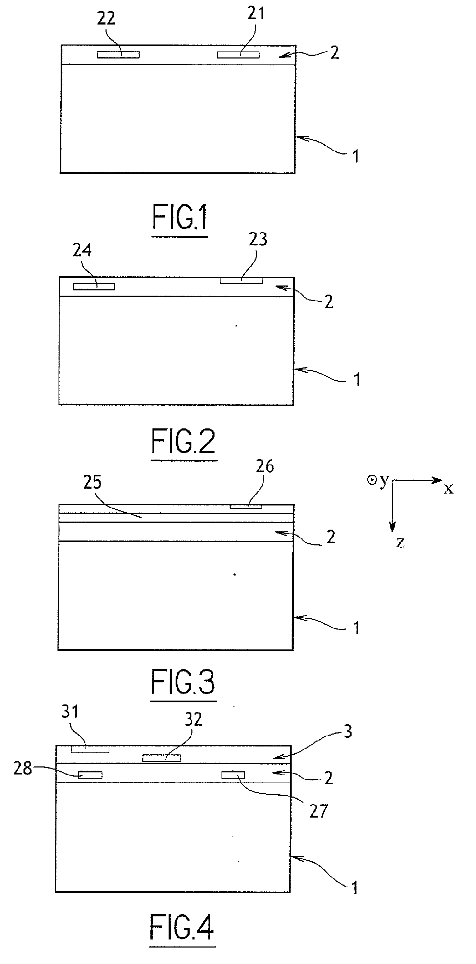

La ou les régions à traiter peuvent être situées en surface de la couche et/ou en profondeur de cette couche, comme illustré sur les figures 1 à 3. Ces figures 1 à 3 représentent une tranche de matériau semi-conducteur formée d'un substrat 1 et d'une couche contrainte 2 sur le substrat 1, ainsi que des régions 21, 22, 23, 24, 25, 26 de la couche contrainte dans lesquelles on souhaite ajuster la contrainte. De manière générale, les régions 21, 22, 23, 24, 25, 26 que l'on souhaite traiter sont définies selon un plan XY et/ou selon la profondeur Z de la couche contrainte 2.

Plus précisément, la figure 1 illustre deux régions 21, 22 situées en profondeur (enterrées) dans la couche contrainte 2, c'est-à-dire situées selon une profondeur Z non nulle depuis la surface de cette couche 2.

La figure 2 illustre quant à elle deux régions 23, 24 dont une 23 est située à la surface de la couche contrainte 2 et l'autre 24 en profondeur de cette couche 2. La figure 3 illustre deux régions 25, 26 de la couche contrainte 2 pour lesquelles on souhaite ajuster la contrainte où l'une 25 est située en profondeur et occupe toute la surface d'intersection du plan XY avec la couche contrainte 2 à une certaine profondeur Z non nulle de la surface de la couche contrainte 2.

L'étape d'implantation d'éléments chimiques doit être effectuée de sorte que la dose d'éléments chimiques implantés soit suffisante pour modifier de manière mesurable l'état de contrainte de la couche contrainte concernée. L'énergie d'implantation, quant à elle, est adaptée en fonction de la profondeur de la région identifiée.

Les éléments chimiques implantés peuvent être des éléments électriquement neutres, de type atomes ou molécules ou des éléments électriquement chargés, de type ions.

Les éléments implantés sont choisis en fonction de la nature de la région cible de la couche contrainte concernée. Il est en effet préférable de choisir des éléments à implanter identiques aux éléments chimiques formant la couche contrainte cible.

Par exemple, on préférera implanter des ions Silicium dans une couche contrainte de Silicium.

De même, si une couche contrainte cible est constituée de plusieurs éléments de natures différentes, on préférera implanter des éléments dont la nature est identique à au moins un des éléments chimiques formant la couche contrainte cible.

Par exemple, on préférera implanter soit du Silicium, soit du Germanium, soit les deux successivement dans une couche contrainte cible formée de Silicium et de Germanium. Deux éléments de natures distinctes peuvent donc être implantés successivement dans la couche contrainte.

Cette implantation permet la modification de l'état de contrainte de la couche cible. Si la couche contrainte cible est en compression, sa contrainte en compression est alors augmentée par l'implantation d'éléments. Au contraire, si la couche contrainte cible est en tension, alors l'implantation d'éléments diminue sa contrainte en extension.

Typiquement, la dose d'éléments chimiques implantés et l'énergie d'implantation sont déterminées afin d'obtenir une variation de l'ordre de 1% de la densité massique avant implantation.

A titre d'exemple, pour une couche contrainte de Silicium dans laquelle l'implantation est effectuée avec des éléments chimiques de type atome, on peut envisager des doses allant de 1e15 à 2e15 atomes/cm² avec une énergie d'implantation comprise entre 10 et 12 keV. Préférentiellement, dans un tel cas, on peut envisager une dose de l'ordre de 2e15 atomes/cm² avec une énergie de l'ordre de 12 keV.

On a évoqué ci-dessus la couche contrainte à laquelle s'applique le procédé, mais bien évidemment le procédé selon l'invention peut s'appliquer à plusieurs couches disposées sur un même substrat comme par exemple pour des structures multicouches de type double-SOI qui peuvent être envisagées dans le cadre de l'invention.

La figure 4 illustre une tranche en matériau semi-conducteur formée d'un substrat 1 et de plusieurs couches contraintes 2, 3 comprenant des régions 27, 28, 31, 32 pour lesquelles on souhaite ajuster la contrainte. Encore une fois, ces régions 27, 28, 31, 32 sont définies selon un plan XY et/ou selon la profondeur Z de la couche contrainte 2.

La seule caractéristique importante d'une couche est qu'elle est contrainte, et cette couche contrainte peut l'être en tension ou en compression, elle peut provenir d'un procédé selon la technologie Smart Cut^{™}, être encore de nature non cristalline, ou comporter des éléments de natures différentes selon la région de cette couche.

Dans le cadre de la présente invention, l'ajustement local de la contrainte dans une région prédéterminée d'une couche peut être effectué grâce à des masques, à l'énergie d'implantation et à la dose d'éléments implantés.

L'étape d'implantation peut être effectuée en une ou plusieurs fois pour une même région. L'étape d'implantation peut également être effectuée plusieurs fois de suite pour ajuster la contrainte locale dans différentes régions d'une ou de plusieurs couches.

L'étape de recuit est quant à elle effectuée sous atmosphère neutre et dans une gamme de température comprise entre 850°C et 950°C sur des durées allant de 2 à 4 heures. Préférentiellement, cette étape de recuit est effectuée sous Argon, à la température constante de 900°C sur une durée de trois heures.

Les deux étapes d'implantation et de recuit peuvent être réalisées une ou plusieurs fois de suite, en commençant toujours par une étape d'implantation.

Pour l'étape d'implantation ou pour l'étape de recuit, le procédé mis en oeuvre doit être réversible.

Par réversible, il faut comprendre pour l'étape d'implantation, que les structures géométriques de la couche cible ou des couches traversées non cibles par les éléments implantés ne sont pas modifiées. Par exemple, un état cristallin de la couche contrainte cible ne doit pas être modifié en un état amorphe de cette couche cible tel qu'il ne serait pas récupérable par l'étape de recuit.

Par réversible, il faut comprendre pour l'étape de recuit, que le niveau de température et la durée de maintien de cette température doit être déterminé de sorte à limiter, entre autres, les phénomènes d'inter-diffusion, accompagnant cette étape de recuit.

On présente ci-dessous un exemple, donné à titre non limitatif, de mise en oeuvre du procédé conforme à la présente invention.

A l'issue d'un procédé de mise en contrainte en tension d'une couche de Silicium, la contrainte est mesurée. La mesure, faite par une métrologie non destructive de type Raman ou diffraction de rayons X, indique un niveau de contrainte de 1600MPa sur une région localisée de la couche. Pour corriger cette valeur d'une centaine de MPa et atteindre ainsi une valeur finale de 1500MPa, on protège d'abord la couche de Silicium par un dépôt TEOS d'une épaisseur de 50 à 150 angströms, préférentiellement 100 angströms, puis l'étape d'implantation est réalisée avec des atomes de Silicium à une dose de 2^{e}15 atomes/cm² avec une énergie de 12keV et l'étape de recuit faite selon les modalités exprimées ci-dessus.

Bien entendu, la présente invention n'est pas limitée aux modes de réalisation présentés ci-dessus, mais s'étend à tout procédé conforme à son esprit, c'est-à-dire à tout procédé visant à ajuster la contrainte d'une ou de plusieurs couches contraintes et pour une ou plusieurs régions de la ou de chaque couche contrainte cible, à la suite d'un procédé de mise sous contrainte de la ou des couches contraintes concernées.

## Revendications

1. Procédé d'ajustement de la contrainte d'une couche contrainte (2) sur un substrat (1), comprenant les étapes consistant à :
- identifier une ou des régions (21, 22, 23, 24, 25, 26, 27, 28, 31, 32) de la couche contrainte (2, 3) dans lesquelles on souhaite ajuster la contrainte par une mesure de cette contrainte ;
- implanter des éléments dans au moins une des régions (21, 22) de la couche contrainte (2) ainsi identifiées ;
- effectuer un recuit du substrat (1) avec la couche contrainte (2) à une température maintenue pendant une durée suffisante pour guérir les défauts cristallins dus à l'implantation dans la (21) ou les régions implantées (21, 22).

2. Procédé selon la revendication 1, dans lequel l'ajustement de la contrainte est local.

3. Procédé selon l'une des revendications précédentes, dans lequel la couche contrainte (3) est superficielle.

4. Procédé selon l'une des revendications 1 ou 2, dans lequel la couche contrainte (2) est enterrée.

5. Procédé selon l'une des revendications précédentes, dans lequel la région identifiée (23, 26, 31) est située à la surface de la couche contrainte (2, 3).

6. Procédé selon l'une des revendications 1 à 4, dans lequel la région identifiée (21, 22) est une région enterrée dans la couche contrainte.

7. Procédé selon l'une des revendications précédentes, dans lequel les éléments implantés sont de nature identique à au moins l'un des éléments chimiques formant la couche contrainte (2, 3).

8. Procédé selon l'une des revendications précédentes, dans lequel l'étape de recuit est effectuée dans une gamme de température comprise entre 850°C et 950°C.

9. Procédé selon l'une des revendications précédentes, dans lequel l'étape de recuit est effectuée à température constante pour une durée comprise entre deux et quatre heures.

10. Procédé selon l'une des revendications précédentes, dans lequel l'étape de recuit est effectuée sous Argon à la température constante de 900°C pour une durée de trois heures.

11. Procédé selon l'une des revendications précédentes, dans lequel on effectue plusieurs fois de suite l'étape d'implantation suivie de l'étape de recuit, pour traiter plusieurs régions (21, 22) de la couche contrainte (2).

12. Couche contrainte ayant fait l'objet d'un procédé conforme à l'une des revendications précédentes.

13. Tranche de matériau semi-conducteur comprenant au moins une couche contrainte selon la revendication 12.
